# DEMANDE DE BREVET EUROPEEN

(11) **EP 1 073 184 A1**
(43) Date de publication de la demande: **31.01.2001**
(21) Numéro de dépôt: 00410083.0
(22) Date de dépôt: 28.07.2000
(51) Int. Cl.: H02M 1/08, H03K 17/13

(54) **Structure monolithique de commande au zéro de tension d'un commutateur bidirectionnel à seuil stable**

(30) Priorité: 28.07.1999 FR 9909986
(71) Demandeur: STMicroelectronics SA, 94250 Gentilly Cedex (FR)
(72) Inventeur: Duclos, Franck, 37000 Tours (FR); Ladiray, Olivier, La Miltière, 37270 Montlouis sur Loire (FR); Simonnet, Jean-Michel, 37270 Veretz (FR)
(74) Mandataire: de Beaumont, Michel

(57) **Abrégé**

L'invention concerne un circuit de commande au zéro de tension d'un commutateur bidirectionnel (TR) comprenant deux transistors de types complémentaires (Q1, Q2) connectés en parallèle entre la gâchette (G) du commutateur bidirectionnel et la borne principale de référence (A1) du commutateur bidirectionnel, la gâchette du commutateur bidirectionnel étant reliée à une source de commande par l'intermédiaire d'une première résistance (R2), et chacune des bornes de commande des transistors étant reliée à la deuxième borne principale (A2) du commutateur bidirectionnel par l'intermédiaire d'une deuxième résistance (R1) de forte valeur, une diode Zener (Z1, Z2) étant interposée entre la deuxième résistance (R1) et chacune des bornes de commande selon une polarité propre à mettre en conduction chacun des transistors quand le seuil Zener est dépassé.

## Description

La présente invention concerne la commande de commutateurs bidirectionnels de moyenne puissance, tels que, par exemple, des triacs.

Un commutateur bidirectionnel comprend deux bornes principales A1 et A2 et une gâchette G. Un commutateur bidirectionnel est susceptible d'entrer en conduction quand un potentiel positif ou négatif existe entre ces bornes A1 et A2 et qu'une impulsion de courant - négative ou positive - est amenée à circuler entre la borne de commande et la borne A1 que l'on appellera borne de référence. Le commutateur bidirectionnel reste ensuite conducteur jusqu'à ce que le courant qui le traverse passe par zéro.

Dans de nombreux cas, on souhaite n'autoriser la mise en conduction d'un commutateur bidirectionnel que quand la tension entre ses bornes principales est proche de zéro. On appelle ce type de commande une commande au zéro de tension bien que, en fait, elle se produise alors que la tension aux bornes du commutateur bidirectionnel est suffisante pour permettre sa mise en conduction, par exemple de l'ordre d'une dizaine de volts.

Plusieurs circuits connus réalisent cette fonction. La figure 1 illustre un tel circuit de commande au zéro de tension décrit dans la demande de brevet européen N° 0 837 545 de la demanderesse. Un commutateur bidirectionnel TR est relié par une borne principale A2 à une charge L, la connexion en série de la charge L et du commutateur bidirectionnel TR étant connectée entre des bornes de tension alternative I1, I2, par exemple le secteur. La borne I1 est à un potentiel de référence, par exemple la masse et est reliée à la borne principale A1 ou borne de référence du commutateur bidirectionnel.

Deux transistors complémentaires sont connectés entre la gâchette G et la borne de référence A1 du commutateur bidirectionnel TR. Ces transistors complémentaires sont un transistor bipolaire de type NPN Q1 et un transistor bipolaire de type PNP Q2. L'émetteur du transistor Q1 et le collecteur du transistor Q2 sont reliés à la gâchette G. Le collecteur du transistor Q1 et l'émetteur du transistor Q2 sont reliés à la borne A1 du commutateur bidirectionnel TR. Les bases des transistors Q1 et Q2 sont reliées l'une à l'autre et à la borne A2 par l'intermédiaire d'une résistance de forte valeur R1. L'ordre de commande est appliqué entre des bornes I3 et I4. La borne I4 est reliée à la borne I1 et constitue une borne de référence. La borne I3 est reliée à la gâchette G par l'intermédiaire d'une résistance R2. L'ordre de commande est un signal ayant une valeur de 0 volt (le potentiel des bornes I1 et I4) quand on ne souhaite pas que le commutateur bidirectionnel soit mis en conduction et une valeur négative, par exemple -5 volts, quand on souhaite commander le commutateur bidirectionnel en conduction.

Le fonctionnement de ce circuit est le suivant.

Quand la tension sur la borne I2 est élevée, l'un ou l'autre des transistors Q1 ou Q2 est commandé à l'état passant. Les bornes G et A1 sont alors court-circuitées par l'un ou l'autre des transistors et aucun courant de commande ne peut circuler entre les bornes G et A1. Le commutateur bidirectionnel TR est donc ouvert.

Quand la tension sur la borne I2 est inférieure à un certain seuil, les deux transistors Q1 et Q2 sont ouverts et, si la tension sur la borne de commande I3 est négative, un courant circulera de la borne A1 à la borne G et entraînera la mise en conduction du commutateur bidirectionnel TR. Ainsi, on peut considérer que l'application d'un ordre de commande (potentiel négatif) sur la borne I3 est retardée jusqu'à ce que le potentiel sur la borne A2 ait chuté à une valeur faible par rapport au potentiel sur la borne A1.

Ensuite, le commutateur bidirectionnel TR s'ouvrira chaque fois que la tension à ses bornes chute et devient voisine d'une valeur nulle. Le commutateur bidirectionnel sera ensuite remis en conduction au début de l'alternance suivante (positive ou négative) si l'ordre de commande est toujours présent.

Un inconvénient de ce type de circuit réside dans le fait que ses seuils de commutation positif et négatif, c'est-à-dire la différence de tension aux bornes des transistors Q1 et Q2 au-delà de laquelle l'un d'eux est bloqué, ne sont pas connus avec précision. En effet, ces seuils, de l'ordre de quelques volts, typiquement d'environ 10 volts, dépendent notamment de la valeur de la résistance R1 et du gain des transistors. Or d'une part, il est relativement complexe d'obtenir des transistors complémentaires Q1 et Q2 de gains identiques. D'autre part, les gains de chacun des transistors vont varier pendant leur durée de vie, notamment en fonction de la température. On observe donc expérimentalement une dispersion de la valeur des tensions maximales positive et négative au-delà desquelles le commutateur bidirectionnel est inhibé.

Un objet de la présente invention est de proposer des modes de réalisation sous forme monolithique de nouveaux circuits de commande au zéro de tension d'un commutateur bidirectionnel qui permettent de stabiliser la valeur de la tension au-delà de laquelle le commutateur bidirectionnel est inhibé.

Un autre objet de la présente invention est de proposer une telle structure monolithique dans laquelle les seuils d'inhibition positif et négatif soient identiques.

Pour atteindre ces objets, la présente invention prévoit une réalisation sous forme de structure monolithique d'un circuit de commande au zéro de tension d'un commutateur bidirectionnel comprenant deux transistors de types complémentaires connectés en parallèle entre la gâchette du commutateur bidirectionnel et la borne principale de référence du commutateur bidirectionnel, la gâchette du commutateur bidirectionnel étant reliée à une source de commande par l'intermédiaire d'une première résistance, et chacune des bornes de commande des transistors étant reliée à la deuxième borne principale du commutateur bidirectionnel par l'intermédiaire d'une deuxième résistance de forte valeur, une diode Zener étant interposée entre la. deuxième résistance et chacune des bornes de commande selon une polarité propre à mettre en conduction chacun des transistors quand le seuil Zener est dépassé. Selon la présente invention, le circuit de commande est formé dans un même substrat semiconducteur d'un premier type de conductivité que le commutateur bidirectionnel.

Selon un mode de réalisation de la présente invention, les bornes de commande des transistors sont interconnectées et les diodes Zener sont connectées en série, et en opposition entre la deuxième résistance et le point d'interconnexion des bornes de commande.

Selon un mode de réalisation de la présente invention, la deuxième résistance est réalisée dans une même première partie du substrat que le commutateur bidirectionnel.

Selon un mode de réalisation de la présente invention, les diodes Zener sont réalisées du côté de la face avant du substrat dans une couche du deuxième type de conductivité, comportant, du côté de la face avant, deux régions du premier type de conductivité, solidaires de métallisations et une région étant formée, par diffusion profonde à partir de la face avant, sous et en contact avec la couche.

Selon un mode de réalisation de la présente invention, une première diode Zener est formée dans une même partie du substrat que l'un des transistors complémentaires.

Selon un mode de réalisation de la présente invention, une deuxième diode Zener est réalisée dans une partie du substrat distincte d'une partie où est réalisé le deuxième transistor.

Selon un mode de réalisation de la présente invention, une deuxième diode Zener est réalisée dans une même partie du substrat que le deuxième transistor.

Selon un mode de réalisation de la présente invention, les deux transistors comlplémentaires sont de type bipolaire.

Selon un mode de réalisation de la présente invention, les deux transistors complémentaires sont de type MOS.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un exemple de circuit de commande au zéro de tension d'un commutateur bidirectionnel ;
la figure 2 représente un autre exemple d'un circuit de commande au zéro de tension d'un commutateur bidirectionnel ;
la figure 3 illustre une réalisation sous forme monolithique selon la présente invention du circuit de commande de la figure 2 ;
la figure 4 représente un autre exemple d'un circuit de commande au zéro de tension d'un commutateur bidirectionnel ; et
les figures 5 et 6 illustrent des variantes de réalisation sous forme monolithique selon la présente invention du circuit de commande de la figure 4.

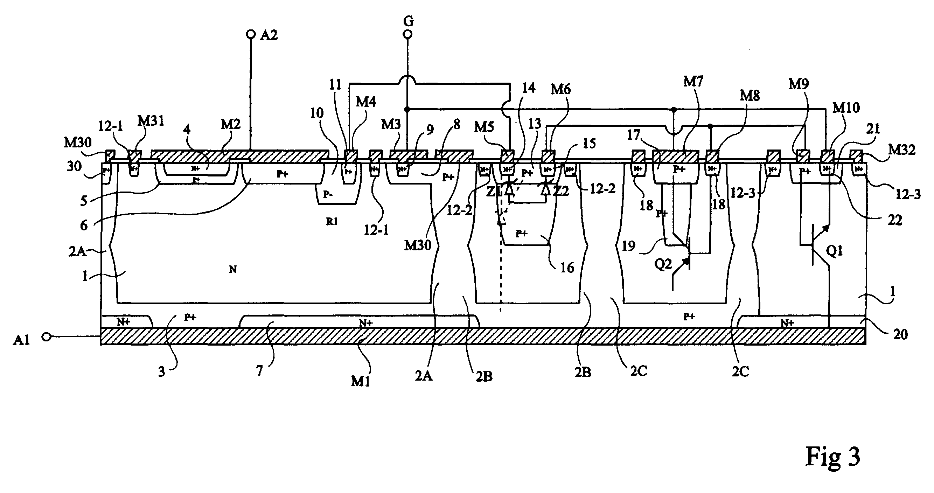

Par souci de clarté, les mêmes éléments ont été désignés par les mêmes références aux différentes figures et, de plus, comme cela est habituel dans la représentation des circuits intégrés, les figures 3, 5 et 6 ne sont pas tracées à l'échelle.

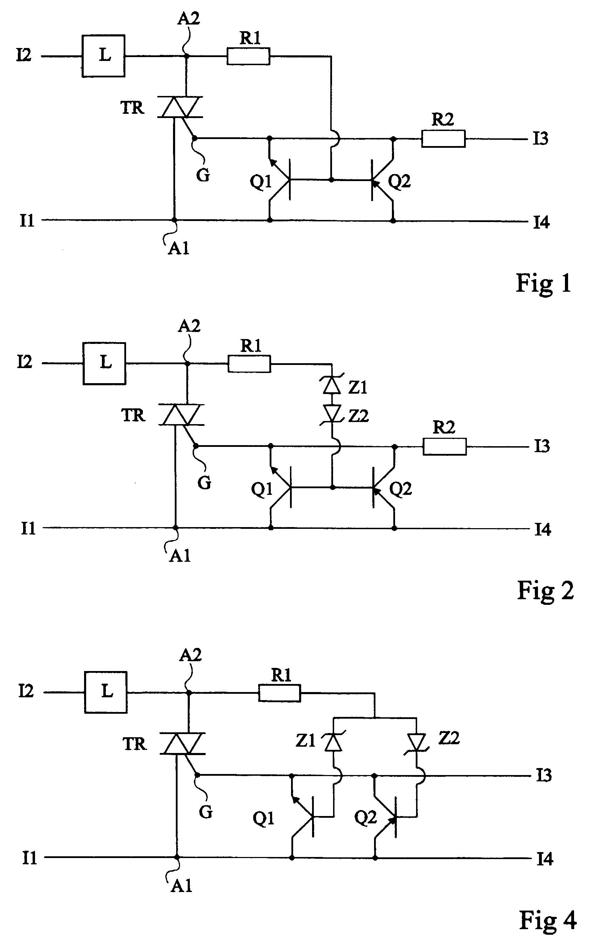

La figure 2 représente un premier exemple d'un circuit de commande au zéro de tension d'un commutateur bidirectionnel que la présente invention vise à réaliser sous forme monolithique. Le circuit est identique à celui de la figure 1 sauf en ce que deux diodes Zener Z1 et Z2 sont interconnectées en série, tête-bêche, entre la résistance R1 et les bases interconnectées des transistors Q1 et Q2.

Le fonctionnement de ce circuit est similaire à celui du circuit de la figure 1. Toutefois, du fait de la présence des diodes Zener Z1 et Z2, le seuil de commutation est stabilisé.

En effet, le passage d'un courant de base est rendu impossible tant que la tension sur la borne I2 est inférieure à un certain seuil fixe qui dépend uniquement de la valeur fixe de la résistance R1 et du seuil fixé par les diodes Zener. En fixant ce seuil à une valeur appropriée, par exemple de l'ordre de 10 volts, les inconvénients du circuit antérieur sont éliminés.

La figure 3 représente un exemple de réalisation sous forme monolithique selon la présente invention du circuit de commande au zéro de tension de la figure 2. Par souci de clarté, on a représenté sur la figure 3 les symboles de certains composants, à savoir les transistors Q1 et Q2 et les diodes Zener Z1 et Z2.

La structure de la figure 3 est formée à partir d'un substrat semiconducteur 1 d'un premier type de conductivité, par exemple de type N faiblement dopé.

Le substrat 1 est divisé de gauche à droite en quatre parties distinctes séparées par des murs d'isolement 2A, 2B et 2C de type P. De façon classique, les murs 2A, 2B et 2C sont obtenus par diffusion profonde à partir des deux faces du substrat.

La face arrière du substrat 1 est revêtue d'une métallisation M1 correspondant à la borne de référence A1 du commutateur bidirectionnel TR, connectée à la borne de référence d'alimentation I1.

Dans la première partie, à gauche du substrat, se trouvent le commutateur bidirectionnel TR ainsi que la résistance R1. Le comutateur bidirectionnel TR est constitué de deux thyristors en antiparallèle entre les deux bornes A1 et A2. L'anode d'un premier thyristor correspond à une couche 3 de type P du côté de la face arrière du substrat 1. La cathode de ce premier thyristor correspond à une région 4 de type N formée du côté de la face avant dans une couche 5 de type P. L'anode du deuxième thyristor du commutateur bidirectionnel correspond à une couche 6 de type P formée du côté de la face avant. Sa cathode correspond à une région 7 de type N formée dans la couche 3, du côté de la face arrière.

La couche 3 est formée du côté de la face arrière de façon à être présente dans les trois premières parties du substrat.

Les faces supérieures des régions 4 et 6 sont revêtues d'une métallisation M2 correspondant à la borne A2 du commutateur bidirectionnel.

On a également formé, du côté de la face avant, dans une couche 8 de type P, une région 9 de type N. La couche 8 est solidaire du mur d'isolement 2A. La région 9 est solidaire d'une métallisation M3 et constitue la gâchette G du commutateur bidirectionnel.

La résistance R1 est constituée d'une région 10 de type P, formée du côté de la face avant en contact avec la couche 6. La région 10 est plus faiblement dopée que la couche 6 et présente une profondeur de diffusion plus importante. La région 10 comporte en surface, du côté de la face avant, une région 11 de même type P fortement dopée, solidaire d'une métallisation M4.

La première partie du substrat 1 comporte également du côté de la face avant des régions 12-1 d'arrêt de canal de type N entre chacune des régions 5 et 10 d'une part et le mur d'isolement 2A d'autre part.

Dans la deuxième partie du substrat 1, à droite de la première, se trouvent les diodes Zener Z1 et Z2. Leur anode commune correspond à une couche 13 de type P, formée du côté de la face avant. Leurs cathodes respectives correspondent à des régions 14, 15 de type N formées dans la couche 13. Chacune des régions 14 et 15 est solidaire d'une métallisation respective M5 et M6. La métallisation M5 de cathode de la diode Z1 est reliée à la métallisation M4, c'est-à-dire à la résistance R1. La métallisation M6 est reliée aux bases des transistors Q1 et Q2 de la façon décrite ci-après. Des régions d'arrêt de canal 12-2 de type N sont prévues du côté de la face avant du substrat 1 entre la couche 13 et le mur d'isolement 2B. On prévoit également sous la couche 13 de type P une région 16. La région 16, obtenue par exemple par diffusion profonde à partir de la face avant lors de la diffusion des murs d'isolement, est destinée à éviter la formation d'un thyristor parasite, représenté en pointillés à la figure 3, entre une des régions 14, 15 et la couche 3.

Dans la troisième partie du substrat, délimitée par le mur d'isolement 2C, on forme le transistor PNP Q2. L'émetteur du transistor Q2 correspond à la couche 3, sa base étant constituée par le substrat 1. Le collecteur du transistor Q2 est constitué d'une couche 17 de type P formée du côté de la face avant et solidaire d'une métallisation M7 connectée à la métallisation M3 de gâchette G du commutateur bidirectionnel TR. Une région 18 fortement dopée de type N est formée sur une faible profondeur, du côté de la face avant, autour de la couche 17 et est revêtue d'une métallisation de base M8 connectée à la métallisation M6 de cathode de la diode Z2. Pour maximiser le gain du transistor PNP Q2, afin qu'il soit proche de celui du transistor NPN Q1, la structure de la figure 3 comporte également, sous la couche 17, une région 19 de type P. La région 19, obtenue par diffusion profonde à partir de la face avant, permet de réduire localement l'épaisseur du substrat 1. Cela permet de minimiser l'épaisseur de la base du transistor Q2. Alors, le gain de ce transistor, proportionnel à l'inverse de la profondeur de la base, est maximisé.

Dans la quatrième partie du substrat 1, à droite de la figure 3, on forme le transistor NPN Q1. Le collecteur du transistor Q1 correspond à une région 20 de type N formée du côté de la face arrière du substrat 1. Sa base correspond à une couche 21 de type P formée du côté de la face avant et solidaire d'une métallisation M9. L'émetteur du transistor Q1 correspond à une région 22 de type N formée dans la couche 21. La région 22 est solidaire d'une métallisation M10. La métallisation M9 (base du transistor Q1) est connectée à la métallisation M8 (base du transistor Q2) et à la métallisation M6 (cathode de la diode Z2). La métallisation M10 (émetteur du transistor Q1) est connectée à la métallisation M3 (gâchette G du commutateur bidirectionnel). On peut également prévoir dans cette quatrième partie du substrat, autour de la couche 21, du côté de la face avant, une région d'arrêt de canal 12-3 de type N.

Selon un mode de réalisation, le mur d'isolement 2A est solidaire d'une métallisation M30, au moins partiellement par l'intermédiaire d'une région 30 de type P, fortement dopée. Les régions d'arrêt de canal 12-1 et 12-3 peuvent également être solidaires de métallisations M31 et M32.

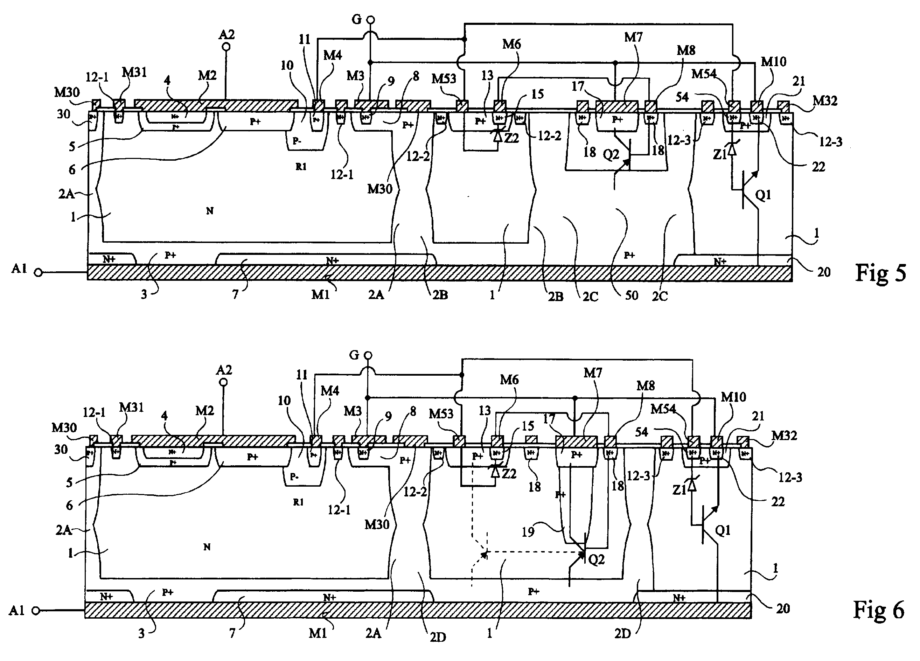

La figure 4 illustre un deuxième exemple d'un circuit de commande au zéro de tension que la présente invention vise à réaliser sous forme monolithique. Les figures 2 et 4 sont similaires. Toutefois, les bases des transistors Q1 et Q2 sont maintenant distinctes et reliées respectivement à l'anode de la diode Z1 et à la cathode de la diode Z2, la cathode de la diode Z1 et l'anode de la diode Z2 étant interconnectées à la résistance R1.

Le fonctionnement du circuit de commande de la figure 4 est similaire à celui de la figure 2. Ce n'est que lorsque la tension sur la borne I2 est inférieure au seuil fixé par la valeur de la résistance R1 et le seuil de l'une ou l'autre des diodes Z1 et Z2, et qui peut être de l'ordre de 10 volts, que les deux transistors Q1 et Q2 sont ouverts et permettent la transmission d'une commande à la gâchette G du commutateur bidirectionnel TR.

La figure 5 illustre un premier mode de réalisation sous forme monolithique selon la présente invention du circuit de commande au zéro de tension de la figure 4.

Selon ce mode de réalisation, on forme, de gauche à droite de la figure, dans une première partie du substrat le commutateur bidirectionnel TR et la résistance R1, dans une deuxième partie la diode Z2, dans une troisième partie le transistor Q2 et dans une quatrième partie le transistor Q1 et la diode Z1.

Le commutateur bidirectionnel TR et la résistance R1 sont réalisés de la même façon qu'en figure 3.

La deuxième partie du substrat 1 contient la diode Zener Z2. Dans la couche 13 de type P est formée uniquement la région 15 de type N correspondant à la cathode de la diode Zener Z2. La couche 13 est solidaire d'une métallisation M53 reliée à la résistance R1 (métallisation M4).

Comparativement au mode de réalisation de la figure 3, on supprime avantageusement la nécessité de prévoir une région diffusée profonde 16 sous la couche 13 pour supprimer un thyristor parasite.

Dans la troisième partie du substrat, on a formé le transistor PNP Q2. Dans l'exemple de la figure 5, on a choisi pour obtenir un transistor à gain élevé de former par diffusion profonde à partir de la face arrière une région 50 de type P. La région 50 peut être formée en même temps que le mur d'isolement 2C. On obtient ainsi un transistor d'épaisseur de base réduite.

On pourrait également utiliser dans le mode de réalisation de la figure 5 un transistor Q2 identique à celui illustré en figure 3. Inversement, on pourrait également utiliser dans l'exemple de la figure 3 un transistor Q2 identique à celui de la figure 5.

Dans la quatrième partie du substrat, on réalise le transistor de type NPN Q1 et la diode Z1. Pour ce faire, outre la région 22 correspondant à l'émetteur du transistor Q1, on forme dans la couche 21 une région 54 de type N constituant la cathode de la diode Z1. La région 54 est solidaire d'une métallisation M54. La métallisation M54 est connectée à la métallisation M4 (résistance R1).

La connexion entre la gâchette G du commutateur bidirectionnel TR, l'émetteur du transistor Q1 et le collecteur du transistor Q2 est assurée de façon identique au mode de réalisation de la figure 3 par l'intermédiaire des métallisations M3, M7 et M10.

La figure 6 illustre un deuxième mode de réalisation sous forme monolithique du circuit de commande selon la présente invention décrit en relation avec la figure 4.

Les parties gauche et droite de la figure 6 sont identiques aux parties homologues de la figure 5. La partie gauche correspond de nouveau à la réalisation d'un commutateur bidirectionnel TR et de la résistance R1. La partie droite correspond à la réalisation du transistor NPN Q1 et de la diode Zener Z1.

La figure 6 diffère de la figure 5 en ce qu'elle ne comporte plus que trois parties. Les deuxième et troisième parties du substrat sont réunies en une unique partie centrale délimitée par un mur d'isolement 2D. Dans cette partie centrale, sont réalisés la diode Zener Z2 et le transistor PNP Q2. Le transistor Q2 est alors formé selon le mode de réalisation décrit en relation avec la figure 3, c'est-à-dire comportant une diffusion profonde 19 de type P sous une couche 17 de type P formée du côté de la face avant. La diode Z2 est constituée comme en figure 5 d'une couche 13 de type P, d'une région de cathode 15 de type N et de métallisations M6 et M53.

Un avantage du mode de réalisation de la figure 6 est de restreindre la surface d'intégration par rapport au mode de réalisation de la figure 5.

Un critère de choix entre les modes de réalisation des figures 5 et 6, outre la surface d'intégration disponible, peut être lié au transistor parasite représenté en traits pointillés qui peut apparaître dans le cas du mode de réalisation de la figure 6. Toutefois, son effet est négligeable. En effet, ce transistor sera activé pour une tension négative supérieure à la tension Zener de la diode Z2. Ce transistor parasite, du même type que le transistor Q2 peut alors prélever une partie de son courant de base. Toutefois, l'épaisseur de la base de ce transistor parasite, l'épaisseur du substrat entre la couche 3 et la couche 13, est très supérieure à celle du transistor Q2, entre la couche 3 et la diffusion profonde 19. Par conséquent, le gain du transistor parasite sera très petit par rapport au gain du transistor Q2. Alors le courant dérivé sera en fait négligeable.

Bien entendu, la présente invention est susceptible de diverses variantes et modifications qui apparaîtront à l'homme de l'art. En particulier, la structure spécifique de commutateur bidirectionnel utilisée dans les exemples de réalisation sous forme monolithique des figures 3, 5 et 6 n'a aucun effet limitatif. La présente invention s'applique à tous types de réalisation sous forme monolithique d'une structure de commutateur bidirectionnel ou d'un réseau de commutateurs bidirectionnels, pour autant qu'il soit muni d'un circuit de commande au zéro de tension.

Dans les modes de réalisation sous forme monolithique (figures 3, 5 et 6), on a considéré que la couche 8 est rendue solidaire du mur d'isolement 2A par une formation en contact direct dans le substrat 1. Toutefois, elle peut être réalisée sans contact avec le mur d'isolement 2A, auquel cas une connexion électrique est assurée en dehors du substrat, par l'intermédiaire de la métallisation M30 et d'une métallisation solidaire de la couche 8.

De plus, on a considéré dans la description précédente le cas particulier où la commande était fournie sous la forme d'une tension négative par rapport à la tension de référence et les transistors Q1 et Q2 ont été connectés en conséquence. Si l'ordre de commande était fourni sous forme d'une impulsion positive, les connexions de collecteur et d'émetteur de chacun des transistors Q1 et Q2 devraient être inversées. La réalisation sous forme monolithique sera alors similaire à l'une quelconque des réalisations décrites précédemment pour une commande négative. Toutefois, du côté du commutateur bidirectionnel, la polarité de la gâchette doit être modifiée. Par exemple, en considérant la structure précédente, la couche 8 sera réalisée sans contact avec le mur d'isolement 2A voisin, la région 9 sera reliée électriquement à ce mur et la couche 8 constituera la gâchette G du commuateur TR. La partie commande sera modifiée de la façon suivante. Les diodes seront réalisées comme précédemment. Le transistor de type PNP Q2 sera réalisé de façon que l'émetteur est situé sur la face supérieure (correspondant, par exemple, à la région 17) et le collecteur sur la face inférieure (correspondant, par exemple, à la couche 3). Le transistor NPN Q1 est réalisé sous forme latérale, son émetteur étant relié à la borne de référence A1/I1, son collecteur étant relié à la commande par l'intermédiaire de la résistance R2. Les connexions électriques sont modifiées de façon appropriée.

Par ailleurs, les modes de réalisation à commande par impulsion positive et à commande par impulsion négative peuvent être combinés. Les bornes de commande des quatre transistors sont alors interconnectées à la cathode de la même diode Z2.

On notera également que les transistors de types complémentaires peuvent être de type MOS. En outre, tous les types de conductivité pourraient être inversés, les polarisations étant alors modifiées de façon correspondante.

## Revendications

1. Structure monolithique d'un circuit de commande au zéro de tension d'un commutateur bidirectionnel (TR) comprenant deux transistors de types complémentaires (Q1, Q2) connectés en parallèle entre la gâchette (G) du commutateur bidirectionnel et la borne principale de référence (A1) du commutateur bidirectionnel, la gâchette du commutateur bidirectionnel étant reliée à une source de commande par l'intermédiaire d'une première résistance (R2), chacune des bornes de commande des transistors étant reliée à la deuxième borne principale (A2) du commutateur bidirectionnel par l'intermédiaire d'une deuxième résistance (R1) de forte valeur, une diode Zener (Z1, Z2) étant interposée entre la deuxième résistance (R1) et chacune des bornes de commande selon une polarité propre à mettre en conduction chacun des transistors quand le seuil Zener est dépassé, caractérisée en ce que le circuit de commande est formé dans un même substrat semiconducteur (1) d'un premier type de conductivité que le commutateur bidirectionnel (TR).

2. Structure selon la revendication 1, caractérisée en ce que les bornes de commande des transistors sont interconnectées et en ce que les diodes Zener (Z1, Z2) sont connectées en série, et en opposition entre la deuxième résistance (R1) et le point d'interconnexion des bornes de commande.

3. Structure selon la revendication 2, caractérisée en ce que la deuxième résistance (R1) est réalisée dans une même première partie du substrat que le commutateur bidirectionnel (TR).

4. Structure selon la revendication 2, caractérisée en ce que les diodes Zener (Z1, Z2) sont réalisées du côté de la face avant du substrat (1) dans une couche (13) du deuxième type de conductivité, comportant, du coté de la face avant, deux régions (14, 15) du premier type de conductivité, solidaires de métallisations (M5, M6) et une région (16) étant formée, par diffusion profonde à partir de la face avant, sous et en contact avec la couche.

5. Structure selon la revendication 1, caractérisée en ce qu'une première diode Zener (Z1) est formée dans une même partie du substrat (1) que l'un des transistors complémentaires (Q1).

6. Structure selon la revendication 5, caractérisée en ce qu'une deuxième diode Zener (Z2) est réalisée dans une partie du substrat distincte d'une partie où est réalisé le deuxième transistor (Q2).

7. Structure selon la revendication 5, caractérisée en ce qu'une deuxième diode Zener (Z2) est réalisée dans une même partie du substrat que le deuxième transistor (Q2).

8. Structure selon l'une quelconque des revendications 1 à 7, caractérisée en ce que les deux transistors complémentaires (Q1, Q2) sont de type bipolaire.

9. Structure selon l'une quelconque des revendications 1 à 8, caractérisée en ce que les deux transistors complémentaires (Q1, Q2) sont de type MOS.
